# EUROPÄISCHE PATENTSCHRIFT

(11) **EP 0 240 039 B1**
(45) Veröffentlichungstag und Bekanntmachung des Hinweises auf die Patenterteilung: **31.03.1993**
(21) Anmeldenummer: 87200203.5
(22) Anmeldetag: 10.02.1987
(51) Int. Cl.: B23K 35/14

(54) **Lotträger**
Solder carrier
Support de soudure

(30) Priorität: 12.03.1986 DE 3608101
(43) Veröffentlichungstag der Anmeldung: 07.10.1987
(73) Patentinhaber: METALLGESELLSCHAFT AG, 60015 Frankfurt (DE)
(72) Erfinder: Reimann, Hartwig, Dr., D-6237 Liederbach (DE); Kruske, Gerhard, D-Oberursel 5 (DE)
(74) Vertreter: Rieger, Harald, Dr.

(56) Entgegenhaltungen:
- EP-A- 0 049 489
- CH-A- 254 862
- CH-A- 300 086
- DE-C- 396 759
- DE-C- 959 343
- FR-A- 742 490
- US-A- 2 694 852
- US-A- 3 472 365
- PATENT ABSTRACTS OF JAPAN, Band 2, Nr. 155, 26. Dezember 1978, Seite 3809 C 78; & JP-A-53 122 652 (TOKYO SHIBAURA DENKI K.K.) 26.10.1978

## Beschreibung

Die Erfindung betrifft einen Lotträger mit in Ausnehmungen bzw. Vertiefungen deponiertem Lotwerkstoff zum Löten mit eingelegtem Lot zur Herstellung einer Lötverbindung zwischen Werkstücken mit parallelwandigem, vorzugsweise großflächigem Lötspalt.

Beim Löten mit eingelegtem Lot ist eine genau abgemessene Lotmenge in dem zwischen den beiden zu verlötenden Werkstücken bestehenden Lötspalt deponiert. Der eingeschlossene Lotwerkstoff erhält die zum Schmelzen benötigte Wärmemenge mittels Wärmeleitung durch die von außen her erwärmten Werkstücke oder durch Wärmestrahlung. Diese Arbeitsweise stellt ein einfaches und sicheres und letzten Endes auch wirtschaftliches Lötverfahren dar, das sich durch kurze Lotfließwege, einen hohen Lötspaltfüllgrad und eine genau bemeßbare Lotmenge sowie einwandfreie Lötverbindungen auszeichnet. Bei diesem Verfahren verwendet man als Lotwerkstoffe Lotformteile, die in Form und Menge auf die Größe des Lötspalts abgestimmt sind, wie ausgestanzte Abschnitte, Ringe, Scheiben sowie Stanzteile in jeder dem Lötspalt angepaßten Form. Bekannt sind ferner blechförmige Lotformteile sowie in dem Lötspalt deponierbare Lotpulver, ggf. unter Hinzufügung eines Haftvermittlers oder Lotpasten. In dem Bestreben, die zur Erzielung einer einwandfreien Lötverbindung abgemessene Lotmenge so niedrig wie möglich zu halten, ist es aus der EP-A-0 049 489 für das Löten von dünnen Blechen bekannt, auf den zu lötenden Flächen einen bei Löttemperatur rückstandsfrei verdampfenden Haftkleber aufzutragen, diesen mit einem trockenen Lotpulver von kleiner und bestimmter Korngröße zu bestäuben, die miteinander zu verlötenden Flächen aufeinanderzupressen und dann die Bleche auf Löttemperatur zu erwärmen. Durch die Korngröße des Lotpulvers, das nur in einzelnen nebeneinander liegenden Lotteilchen haftet, soll die Menge des Lotpulvers pro Fläche hinreichend dosierbar und eng begrenzbar sein. Dieses Verfahren ist besonders zum Löten von Katalysatorkörpern aus warmfesten oder hochtemperaturbeständigen Werkstoffen, die spiralig aus einem gewellten und einem flachen Blechband gewickelt sind, vorgesehen. Abgesehen davon, daß bei zylinderförmigen Werkstücken, die ineinandergesteckt miteinander verlötet werden sollen, die Lotpulverschicht ganz oder teilweise beim Ineinanderstecken des einen Werkstücks in das andere abgetragen wird, hat sich als Nachteil herausgestellt, daß der Platzwechsel zwischen Lot und Werkstücken unterbrochen, die Lötstellenoberfläche nicht in ausreichendem Maß benetzt und damit die Güte der Lötverbindung erheblich beeinträchtigt wird, da es zu Gaseinschlüssen sowie zur Lunkerbildung in der Lötverbindung - soweit überhaupt eine solche gebildet wird - kommt. Auch verändert sich das Volumen von Lotpulver und Haftkleber während des Lötvorgangs, so daß der größer werdende Lötspalt nur einen geringen Füllgrad und damit die Lötverbindung eine unzureichende Festigkeit aufweisen. Außerdem verändert sich bei einer Vielzahl von aufeinandergeschichteten und im Paket zu lötenden Platten die Sollbauhöhe in unzulässiger Weise. In der DE-A-396 759 sind Lötstreifen mit die Lötmasse und das Flußmittel aufnehmenden Längsnuten auf mehreren Seitenflächen vorgesehen, um Platten stumpf miteinander verschweißen zu können. Die FR-A-742 490 beschreibt einen Lotträger, der aus parallel verlaufenden Drähten, von denen abwechselnd der eine gerade und der andere gewellt ausgebildet ist, besteht. Schließlich ist aus der CH-A-300 086 ein Lötkörper bekannt, bei dem ein Lötmittel in Vertiefungen eines Lotes untergebracht ist.

Es ist die Aufgabe der vorliegenden Erfindung, einen Lotträger der eingangs beschriebenen Art so zu gestalten, daß bei möglichst geringem Verbrauch an Lotwerkstoff gleichzeitig eine hohe Güte der Lötverbindung gewährleistet ist.

Gelöst ist diese Aufgabe dadurch, daß der Lotträger erfindungsgemäß aus Blech einer Dicke von 0,01 bis 2,50 mm, vorzugsweise 0,04 bis 0,40 mm, besteht.

Im Rahmen der Ausgestaltung des erfindungsgemäßen Lotträgers ist dieser mit mit Lotwerkstoff ausgefüllten Durchbrechungen versehen.

Zweckmäßigerweise besteht der Lotträger aus einem Lochblech oder Streckmetall.

Durch Walzen oder Pressen kann der Lotträger zusätzlich so verformt werden, daß die Durchbrechungen teilweise geschlossen und der Lotwerkstoff verdichtet ist, damit dieser nicht aus den Durchbrechungen herausfallen kann.

Es ist auch möglich, als Lotträger ein gewelltes Blech einzusetzen, dessen Vertiefungen mit Lotwerkstoff ausgefüllt sind.

Der Lotträger kann auch als Werkstück ausgebildet sein.

Der Lotwerkstoff selbst kann pulverförmig sein oder aus ausgestanzten Formteilen, wie Ronden, Scheiben oder dergleichen, deren Form den Ausnehmungen bzw. Vertiefungen angepaßt ist, bestehen.

Im Rahmen der zweckmäßigen Ausbildung der Erfindung besteht der in den Ausnehmungen bzw. Vertiefungen deponierte Lotwerkstoff aus Pulver oder ausgestanzten Formteilen, wie Ronden, Scheiben oder dergleichen in jeder den Ausnehmungen bzw. Vertiefungen angepaßten Form, kann in Kombination mit Flußmitteln in Form von Lötmassen oder Lötpasten vorliegen und/oder unter Verwendung eines Haftvermittlers in den Ausnehmungen bzw. Vertiefungen deponiert sein.

Auch kann der Lotträger aus zwei Metallfolien von 0,01 bis 0,05 mm Dicke, zwischen denen der Lotwerkstoff deponiert ist, gebildet sein, wobei nach einem weiteren Erfindungsmerkmal der Lotwerkstoff durch Walzen oder Pressen der beiden Metallfolien verdichtet ist. Dieser Lotträger dient zur Herstellung einer Lötverbindung zwischen Werkstücken mit parallelwandigem, vorzugsweise großflächigem Lötspalt.

Nach einem weiteren Merkmal der Erfindung können die Metallfolien mit Soll-Löslichkeitsstellen versehen sein, an denen beim Erwärmen das Lot die Metallfolien durchbricht und in den jeweils zwischen der Metallfolie und der gegenüberliegenden Werkstückwand befindlichen Lötspalt fließt, so daß die Lötverbindung der beiden Werkstücke über die durch das Lot miteinander fest verbundenen, teilweise aufgeschmolzenen Metallfolien erfolgt.

Der blechförmige Lotträger wird aufgrund des hohen Diffusions- und Penetrationsvermögens bzw. Erosionsverhaltens des Lotwerkstoffs ganz oder teilweise beim Lötvorgang aufgelöst, wobei das austretende Lot die Lötstellen der zu verbindenden Werkstücke benetzt.

Eine besondere Ausgestaltung des Lotträgers ist darin zu sehen, daß wenigstens eines der durch Löten zu verbindenden Werkstücke blechförmig und mit Durchbrechungen mit darin deponiertem Lotwerkstoff versehen ist. Diese Maßnahme ist besonders für die Herstellung von aus einem gewellten und aus einem flachen Blechband schichtartig aufgebauten Bauteilen, beispielsweise von Kühlaggregaten oder Katalysatoren, geeignet. Dabei übernimmt eines der Werkstücke des Bauteils gleichzeitig die Funktion eines Lotträgers. Der in den Durchbrechungen des Blechbandes deponierte Lotwerkstoff beeinträchtigt in keiner Weise die Maßhaltigkeit des zu erzeugenden Bauteils.

Der erfindungsgemäß ausgebildete Lotträger eignet sich für alle Anwendungsfälle, bei denen mit Weich-, Hart- oder Hochtemperatur-Lotwerkstoffen gearbeitet wird, ebenso wie für das Löten von Werkstücken mit engem und weitem Lötspalt. Der Lotträger ermöglicht eine genau abgemessene Menge an Lotwerkstoff, was sich insbesondere dann vorteilhaft auswirkt, wenn aus Gründen der Festigkeit und des Korrosionsschutzes vergleichsweise teure Lotwerkstoffe, z.B. auf der Basis von AgCd, AgPd, NiCrBSi oder NiCrP, zur Herstellung der Lötverbindung erforderlich sind. Darüber hinaus ist eine bessere und sicherere Anpassung der Lotwerkstoffmenge an die Größe des Lötspalts und an die Größe der zu lötenden Fläche möglich, insbesondere in den Fällen, in denen nur partielle Lötverbindungen zwischen den Werkstücken vorgesehen sind. Da der Lotträger eine genaue Dosierung des Lotwerkstoffs erlaubt, können Lotwerkstoffe mit hohem Diffusions- und Penetrationsvermögen bzw. Erosionsverhalten genau an die Dicke der Werkstücke angepaßt werden, so daß der Nachteil eines zu großen Angebots an Lotwerkstoff, das zu einer Zerstörung des Werkstoffs führen kann, vermieden wird. Der Lotträger führt ferner dazu, daß das Lot keine zu breiten Überbrückungen zwischen den Werkstücken bildet und somit eine größere Festigkeit der Lötverbindung erzielt wird.

Die Erfindung ist im folgenden anhand mehrerer Ausführungsbeispiele näher erläutert.

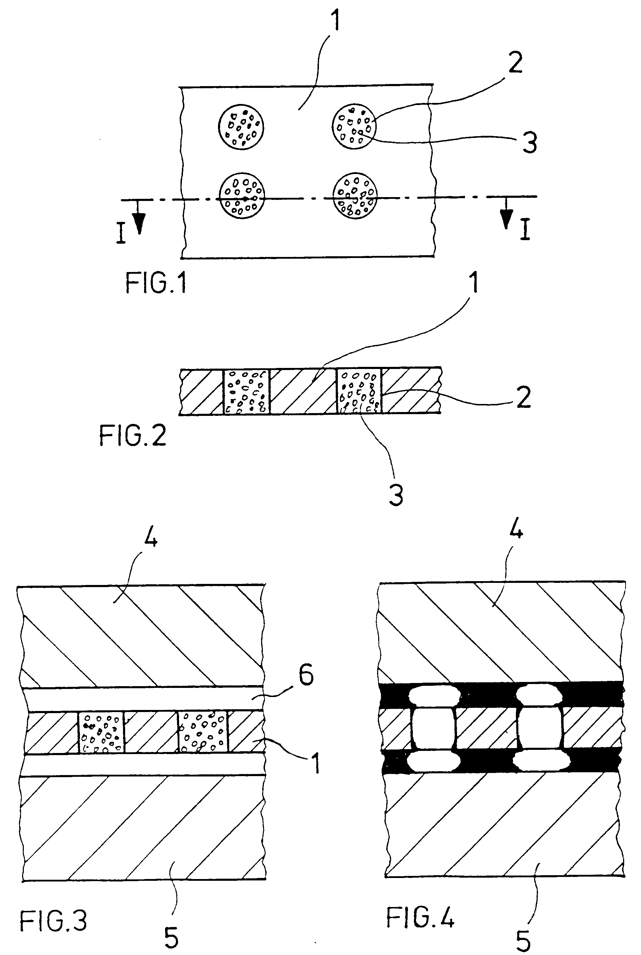

In Fig. 1 ist eine Draufsicht auf einen Teil eines aus austenitischem Stahl bestehenden Lotträgers (1) von 0,2 mm Dicke dargestellt, in dessen Durchbrechungen (2) ein pastenförmiger Lotwerkstoff (3) deponiert ist. Fig. 2 zeigt einen Querschnitt entlang der Schnittlinie I-I der Fig. 1.

Gemäß dem in Fig. 3 wiedergegebenen Querschnitt ist der Lotträger (1) in den zwischen den beiden Werkstücken (4,5) vorhandenen Lötspalt (6) eingelegt. Durch Erwärmen der Werkstücke (4,5) ist, wie Fig. 4 zeigt, der Lotwerkstoff aus den Durchbrechungen (2) in den zwischen dem Lotträger (1) und den gegenüberliegenden Verbindungsstellen der Werkstücke (4,5) jeweils befindlichen Lötspalt geflossen, so daß dadurch eine feste Lötverbindung zwischen den Werkstücken (4,5) entstanden ist.

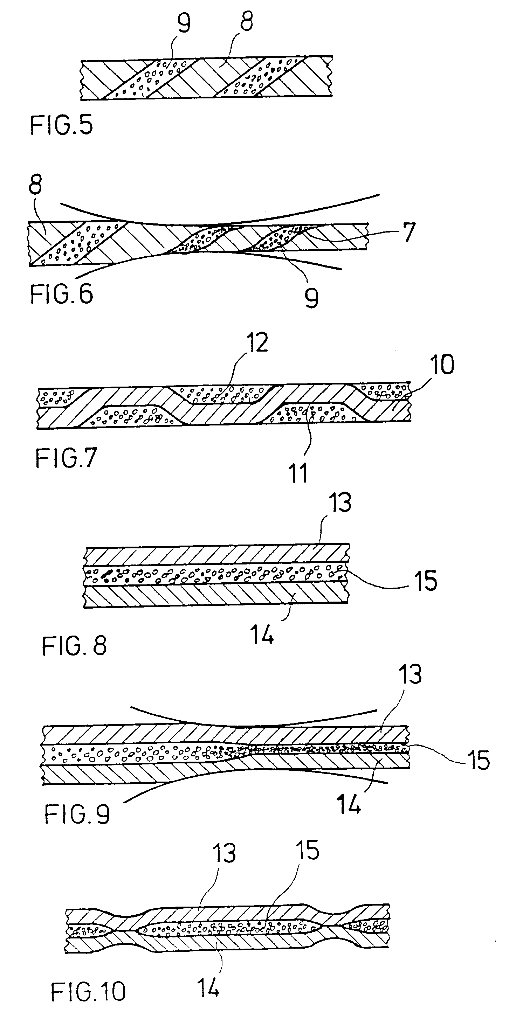

Durch die geneigte Anordnung der Durchbrechungen (7) bei dem in Fig. 5 im Querschnitt gezeigten Lotträger (8), bestehend aus einer Kupferlegierung, läßt sich das Volumen der einzelnen Durchbrechungen gegenüber senkrechten Durchbrechungen und damit die deponierte Menge an Lotwerkstoff vergleichsweise vergrößern. Durch Walzen des Lotträgers (8) ist erreicht, daß der in den Durchbrechungen (7) befindliche Lotwerkstoff (9) verdichtet und die Durchbrechungen gemäß Fig. 6 teilweise geschlossen sind.

Bei dem in Fig. 7 im Querschnitt dargestellten trapezförmig gewellten Lotträger (10) aus einer Aluminiumlegierung sind dessen Vertiefungen (11) mit dem Lotwerkstoff (12) ausgefüllt.

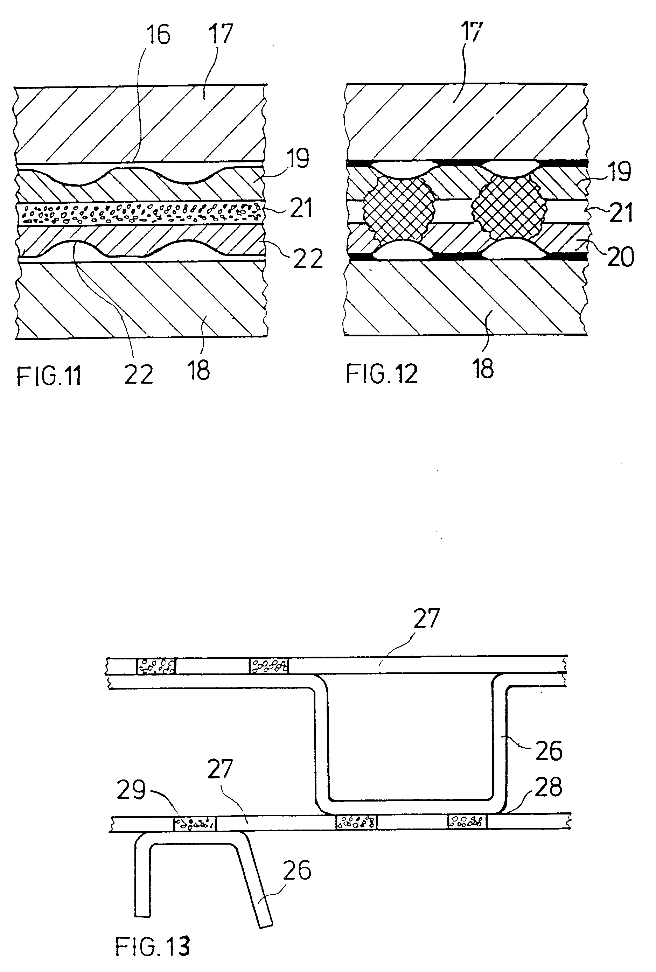

Der in Fig. 8 wiedergegebene Lotträger besteht aus den Metallfolien (13,14), zwischen denen der Lotwerkstoff (15) deponiert ist. Durch Walzen der beiden Metallfolien (13,14) ist, wie in Fig. 9 dargestellt, der Lotwerkstoff verdichtet. Durch eine zusätzliche Rändelung können gemäß Fig. 10 die Metallfolien (13,14) in der Weise gegeneinander verformt sein, daß der Lotwerkstoff (15) in einzelnen Paketen im Lotträger angeordnet ist. Der in Fig. 11 dargestellte Querschnitt zeigt einen in den Lötspalt (16) zwischen den beiden Werkstücken (17,18) eingelegten Lotträger, bestehend aus den Metallfolien (19,20), zwischen denen der Lotwerkstoff (21) deponiert ist. Die Metallfolien (19,20) weisen in regelmäßigen Abständen angeordnete Ausnehmungen (22) auf, die beim Erwärmen der Werkstücke (17,18) und damit des Lotträgers als Soll-Löslichkeitsstellen dienen. An diesen Stellen tritt gemäß Fig. 12 das Lot in den Lötspalt aus und benetzt die zwischen den Werkstücken (17,18) und den Metallfolien bestehenden Verbindungsstellen, wodurch eine feste Lötverbindung erzielt wird.

In Fig. 13 ist ein ausschnittsweiser Querschnitt durch einen aus einem rechteckförmig gewellten Blechband (23) und einem flachen Blechband (24) gelöteten Kühlerelement dargestellt. Dabei sind in den Bereichen, in denen das flache Blechband (24) mit den Seiten des gewellten Blechbandes (23) einen parallelwandigen Lötspalt (25) bildet, als Lotwerkstoffdepots dienende Durchbrechungen (26) in dem flachen Blechband (24) angebracht.

## Patentansprüche

1. Lotträger mit in Ausnehmungen bzw. Vertiefungen deponiertem Lotwerkstoff zum Löten mit eingelegtem Lot zur Herstellung einer Lötverbindung zwischen Werkstücken mit parallelwandigem, vorzugsweise großflächigem Lötspalt, dadurch gekennzeichnet, daß der Lotträger (1) aus Blech der Dicke 0,01 bis 2,50 mm besteht.

2. Lotträger nach Anspruch 1, gekennzeichnet durch eine Blechdicke von 0,04 bis 0,40 mm.

3. Lotträger nach den Ansprüchen 1 oder 2, gekennzeichnet durch Durchbrechungen (2) mit darin deponiertem Lotwerkstoff (3).

4. Lotträger nach einem der Ansprüche 1 bis 3, gekennzeichnet durch ein Lochblech.

5. Lotträger nach einem der Ansprüche 1 bis 3, gekennzeichnet durch ein Streckmetall.

6. Lotträger nach einem der Ansprüche 1 bis 5, dadurch gekennzeichnet, daß bei dem durch Walzen oder Pressen verformten Lotträger (8) die mit Lotwerkstoff (9) gefüllten Durchbrechungen (7) teilweise geschlossen und der Lotwerkstoff verdichtet ist.

7. Lotträger nach den Ansprüchen 1 oder 2, gekennzeichnet durch ein gewelltes Blech (10) mit in dessen Vertiefungen (11) deponiertem Lotwerkstoff (12).

8. Lotträger nach einem oder mehreren der Ansprüche 1 bis 7, dadurch gekennzeichnet, daß der Lotträger als Werkstück geformt ist.

9. Lotträger nach einem der Ansprüche 1 bis 8, dadurch gekennzeichnet, daß der in den Ausnehmungen bzw. Vertiefungen deponierte Lotwerkstoff aus Pulver oder ausgestanzten Formteilen, wie Ronden, Scheiben oder dergleichen in jeder den Ausnehmungen bzw. Vertiefungen angepaßten Form, besteht.

10. Lotträger nach einem der Ansprüche 1 bis 9, dadurch gekennzeichnet, daß der in den Ausnehmungen bzw. Vertiefungen deponierte Lotwerkstoff in Kombination mit Flußmitteln in Form von Lötmassen oder Lötpasten vorliegt.

11. Lotträger nach einem der Ansprüche 1 bis 10, dadurch gekennzeichnet, daß der Lotwerkstoff unter Verwendung eines Haftvermittlers in den Ausnehmungen bzw. Vertiefungen deponiert ist.

12. Lotträger zum Löten mit eingelegtem Lot zur Herstellung einer Lötverbindung zwischen Werkstücken mit parallelwandigem, vorzugweise großflächigem Lötspalt, gekennzeichnet durch zwei Metallfolien (13,14) von 0,01 bis 0,05 mm Dicke, zwischen denen der Lotwerkstoff (12) deponiert ist.

13. Lotträger nach Anspruch 12, dadurch gekennzeichnet, daß der Lotwerkstoff (12) durch Walzen oder Pressen der Metallfolien (13,14) verdichtet ist.

14. Lotträger nach einem der Ansprüche 12 oder 13, dadurch gekennzeichnet, daß die Metallfolien (19,20) als Soll-Löslichkeitsstellen (22) dienende Bereiche aufweisen.

## Claims

1. A solder carrier with soldering material deposited in recesses or depressions for soldering with inserted solder in order to produce a soldered connection between workpieces having a parallel-walled soldering gap preferably of large surface area, characterised in that the solder carrier (1) is made of sheet metal of a thickness of 0.01 to 2.50 mm.

2. A solder carrier according to Claim 1, characterised by a sheet metal thickness of 0.04 to 0.40 mm.

3. A solder carrier according to Claims 1 or 2, characterised by holes (2) with soldering material (3) deposited therein.

4. A solder carrier according to one of Claims 1 to 3, characterised by a perforated plate.

5. A solder carrier according to one or Claims 1 to 3, characterised by an expanded metal.

6. A solder carrier according to one of Claims 1 to 5, characterised in that in the solder carrier (8) which has been shaped by rolling or pressing the holes (7) filled with soldering material (9) are partially closed and the soldering material is compacted.

7. A solder carrier according to Claims 1 or 2, characterised by a corrugated sheet of metal (10) with soldering material (12) deposited in the depressions (11) thereof.

8. A solder carrier according to one or more of Claims 1 to 7, characterised in that the solder carrier is shaped as a workpiece.

9. A solder carrier according to one of Claims 1 to 8, characterised in that the soldering material deposited in the recesses or depressions consists of powder or cut-out shaped parts, such as circular blanks, discs or the like, in each form adapted to the recesses or depressions.

10. A solder carrier according to one of Claims 1 to 9, characterised in that the soldering material deposited in the recesses or depressions is present in combination with fluxes in the form of soldering compounds or solder pastes.

11. A solder carrier according to one of Claims 1 to 10, characterised in that the soldering material is deposited in the recesses or depressions using an adhesion promoter.

12. A solder carrier for soldering with inserted solder in order to produce a soldered connection between workpieces having a parallel-walled soldering gap preferably of large surface area, characterised by two metal foils (13, 14) of 0.01 to 0.05 mm in thickness, between which the soldering material (12) is deposited.

13. A solder carrier according to Claim 12, characterised in that the soldering material (12) is compacted by rolling or pressing the metal foils (13, 14).

14. A solder carrier according to one of Claims 12 or 13, characterised in that the metal foils (19, 20) have regions which act as desired solubility points (22).

## Revendications

1. Support de soudure comportant de la soudure déposée dans des logements ou dans des cavités pour souder avec de la soudure enrobée, destiné à la fabrication d'un joint soudé entre des pièces ayant un intervalle de soudage à parois parallèles, de préférence de grande surface, caractérisé en ce que le support de soudure (1) est en tôle d'une épaisseur de 0,01 à 2,50 mm.

2. Support de soudure suivant la revendication 1, caractérisé en ce que l'épaisseur de la tôle va de 0,04 à 0,40 mm.

3. Support de soudure suivant l'une des revendications 1 ou 2, caractérisé par des perforations (2) dans lesquelles est déposée de la soudure (3).

4. Support de soudure suivant l'une des revendications 1 à 3, caractérisé par une tôle perforée.

5. Support de soudure suivant l'une des revendications 1 à 3, caractérisé par un métal déployé.

6. Support de soudure suivant l'une des revendications 1 à 5, caractérisé en ce que, dans le cas du support de soudure (8) déformé par laminage ou par compression, les perforations (7) emplies de soudure (9) sont partiellement fermées et la soudure est densifiée.

7. Support de soudure suivant l'une des revendications 1 ou 2, caractérisé par une tôle ondulée (10) ayant de la soudure (12) déposée dans les cavités (11).

8. Support de soudure selon l'une ou plusieurs des revendications 1 à 7, caractérisé en ce que le support de soudure est conformé en une pièce d'usinage.

9. Support de soudure suivant l'une des revendications 1 à 8, caractérisé en ce que la soudure déposée dans les logements ou dans les cavités se présente sous forme de poudre ou de pièces conformées d'éléments de forme, telles que des ronds, des disques ou analogues, de forme adaptée à chaque logement ou cavité.

10. Support de soudure suivant les revendications 1 à 9, caractérisé en ce que la soudure déposée dans les logements ou les cavités se présente en combinaison avec des flux sous forme de peniture à souder ou de pâte à souder.

11. Support de soudure suivant l'une des revendications 1 à 10, caractérisé en ce que la soudure est déposée dans les logements ou les cavités en utilisant un produit adhésif.

12. Support de soudure pour le soudage avec une soudure enrobée pour la fabrication d'un joint soudé entre deux pièces avec un intervalle de soudage à parois parallèles, de préférence de grande surface, caractérisé par deux feuilles métallique (13, 14) de 0,01 à 0,05 mm d'épaisseur, entre lesquelles est déposée la soudure (12).

13. Support de soudure suivant la revendication 12, caractérisé en ce que la soudure (12) est densifiée par laminage ou parcouru des feuilles métalliques (13, 14).

14. Support de soudure suivant l'une des revendications 12 ou 13, caractérisé en ce que les feuilles métalliques (19, 20) comportent des zones servant de points de solubilité (22) obligés.
